# DEMANDE DE BREVET EUROPEEN

(11) **EP 2 369 616 A1**
(43) Date de publication de la demande: **28.09.2011**
(21) Numéro de dépôt: 10305281.7
(22) Date de dépôt: 22.03.2010
(51) Int. Cl.: H01L 21/56, G06K 19/077

(54) **Procédé de fabrication d'un module électronique comportant une puce électronique fixée sur un substrat contenant une antenne**

(71) Demandeur: Gemalto SA, 92190 Meudon (FR)
(72) Inventeur: Bajolle, Antoine, 92197 Meudon Cedex (FR); Gaspari, Sebastien, 92197 Meudon Cedex (FR); Bousquet, Christophe, 92197 Meudon Cedex (FR); Poitrasson, Eric, 92197 Meudon Cedex (FR)

(57) **Abrégé**

La présente invention concerne un procédé de fabrication d'un module électronique comportant une puce électronique fixée sur un substrat contenant une antenne, comportant les étapes suivantes :
- on applique de la résine (24) polymérisable au rayonnement UV et à la chaleur à l'emplacement de fixation de la puce électronique (23) sur le substrat (25),
- on met en place la puce électronique (23) sur son emplacement de fixation, la connectant à l'antenne (26),
- on effectue un traitement de polymérisation de la résine (24) par insolation UV au travers du substrat (25),
- on effectue un traitement thermique de polymérisation de la résine (24).

## Description

La présente invention se rapporte au domaine technique des procédés de fabrication d'un module électronique, et plus particulièrement aux procédés de fabrication d'un module électronique comportant une puce électronique fixée sur un substrat contenant une antenne.

De façon générale, les procédés de fabrication de modules électroniques, comportant notamment une puce électronique fixée sur un substrat contenant une antenne, ou « INLAY » sont bien connus. Ces procédés consistent généralement à coller une puce électronique directement sur le substrat et à connecter par la même à l'antenne fixée sur ledit substrat, au moyen d'une résine, notamment polymérisable sous rayonnement ultraviolet (UV). Un traitement de polymérisation de la résine par insolation UV est ensuite effectué pour fixer la puce sur le substrat

Cependant un procédé de fabrication tel que celui-ci peut engendrer une polymérisation incomplète de la résine de fixation, ce qui peut générer des problèmes de durabilité lors du vieillissement du produit. En effet, il existe des zones « d'ombre », ou le rayonnement UV a du mal atteindre la résine et par conséquent ladite résine ne peut se polymériser correctement dans ces zones « d'ombres ».

Un des buts de la présente invention est donc de proposer un procédé de fabrication de module électronique, comportant notamment une puce électronique fixée sur un substrat contenant une antenne, permettant une cadence de production optimisée et une polymérisation de la résine de fixation optimale.

Ainsi, la présente invention concerne un procédé de fabrication d'un module électronique comportant une puce électronique fixée sur un substrat contenant une antenne, comportant les étapes suivantes :
- on applique de la résine polymérisable au rayonnement UV et à la chaleur à l'emplacement de fixation de la puce électronique sur le substrat,
- on met en place la puce électronique sur son emplacement de fixation, la connectant à l'antenne,
- on effectue un traitement de polymérisation de la résine par insolation UV au travers du substrat,
- on effectue un traitement thermique de polymérisation de la résine.

Le couplage de la polymérisation par insolation UV et par la chaleur permet de polymériser complètement la résine de fixation, et ce y comprit dans les zones « d'ombre » où les rayons UV n'ont pas pu aller, et donc de polymériser correctement la résine de fixation.

Selon un autre mode de réalisation, ledit procédé de fabrication d'un module électronique comprend une étape intermédiaire où l'on superpose sur le substrat une couche compensatrice, munie d'un trou de compensation au niveau de l'emplacement de fixation de la puce électronique, avant l'étape de mise en place de la résine polymérisable aux rayons UV et à la chaleur sur ledit emplacement de fixation de la puce électronique sur le substrat.

Cette couche compensatrice a une double fonction, elle permet de compenser l'épaisseur de la puce électronique et ainsi d'obtenir un module électronique plat, mais ladite couche permet également, du fait qu'elle soit superposée avant l'application de la résine de fixation, de contenir dans le trou de compensation ladite résine de fixation. Le trou de compensation joue ainsi également un rôle de « réservoir » ou de « barrage ».

Selon un autre mode de réalisation, le traitement thermique de polymérisation de la résine est effectué consécutivement au traitement de polymérisation de la résine par insolation UV.

Selon un aspect de l'invention, le traitement thermique de polymérisation de la résine est suivi d'une étape de découpe du substrat au format désiré.

Selon un autre mode de réalisation, le traitement de polymérisation de la résine par insolation UV au travers du substrat est suivi d'une étape de découpe dudit substrat au format désiré.

Selon un autre aspect de l'invention, le traitement thermique de polymérisation de la résine est effectué lors de la lamination des couches au moment de l'encartage dudit module électronique.

Selon un autre mode de réalisation, suite à l'étape de mise en en place de la résine sur l'emplacement de fixation de la puce électronique sur le substrat, on effectue une étape supplémentaire de pré-polymérisation de la résine par insolation UV par dessus l'emplacement de fixation de ladite puce électronique sur ledit substrat.

Cette étape intermédiaire permet une pré-polymérisation de la résine. Cela permet ainsi de polymériser partiellement la résine avant la mise en place de la puce électronique et que ne se forment les zones « d'ombre ».

Selon un autre mode de réalisation, suite à l'étape de mise en place de la puce électronique sur son emplacement de fixation, on effectue une étape supplémentaire où une pellicule de résine, polymérisable sous rayonnement UV et à la chaleur, est déposée sur ladite puce électronique et l'étape suivante de traitement de polymérisation de la résine par d'insolation UV est effectuée aussi bien au travers du substrat que par dessus l'emplacement de fixation de la puce électronique.

Cette pellicule de résine permet, après polymérisation, de former une couche protectrice ou « globe top » au dessus de ladite puce électronique.

Selon un autre aspect de l'invention, la puce électronique est une puce nue.

Selon un autre aspect de l'invention, la puce électronique est une puce enrobée.

Selon un autre aspect de l'invention, la ou les couches formants ledit module électronique se présentent sous forme de feuilles individuelles avant la mise en oeuvre du procédé.

Selon un autre aspect de l'invention, la ou les couches formants ledit module électronique se présentent sous forme de rouleaux avant la mise en oeuvre du procédé.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente un schéma simplifié d'un exemple de module électronique, en vue de coupe et de côté, obtenue selon un mode de réalisation de l'invention.
- la figure 2 représente sous forme d'un organigramme un procédé d'incrustation selon un premier mode de réalisation,
- la figure 3 représente sous forme d'un organigramme un procédé d'incrustation selon un second mode de réalisation,
- la figure 4 représente sous forme d'un organigramme un procédé d'incrustation selon un troisième mode de réalisation,

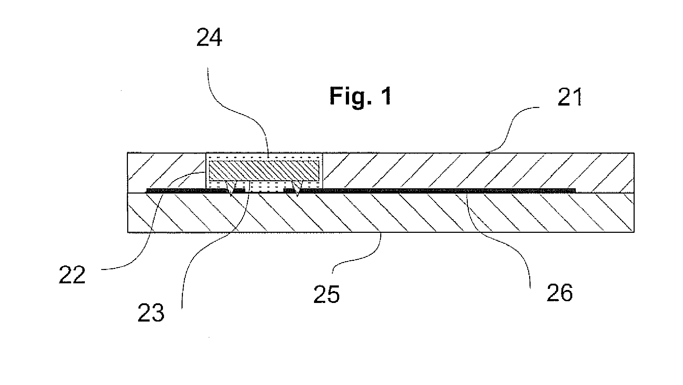

La figure 1 montre un exemple de module électronique, en vue de coupe et de côté, obtenue selon un mode de réalisation de l'invention.

On retrouve ici une couche compensatrice 21 dans laquelle est pratiqué le trou de compensation 22. A l'intérieur dudit trou de compensation 22 est situé une puce électronique 23. Ladite puce 23 est connectée, par des pattes connectives, à une antenne 26 située à la surface du substrat 25. Ladite puce 23 est fixée sur le substrat 25 au moyen de résine 24 polymérisable sous rayonnement UV et à la chaleur.

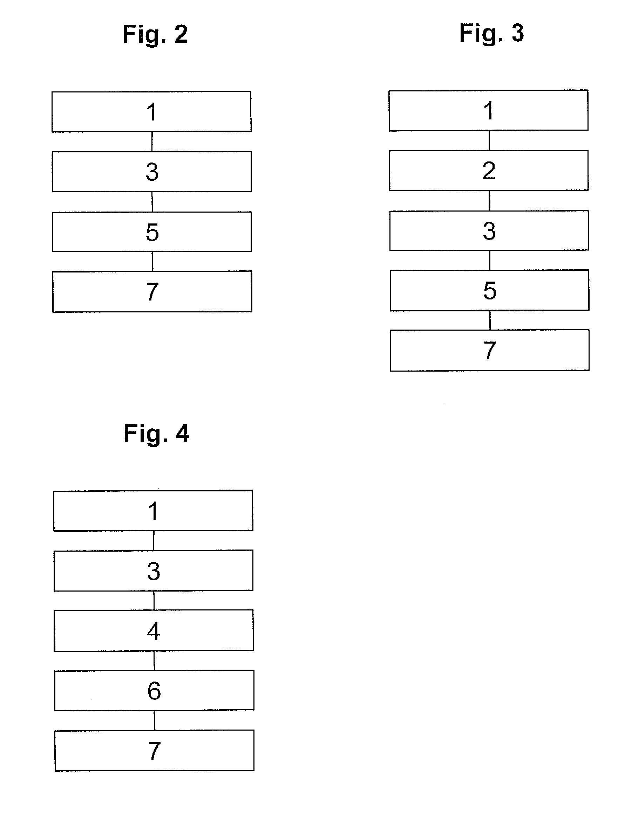

La figure 2 montre sous forme d'organigramme les différentes étapes d'un procédé de fabrication d'un module électronique comportant une puce électronique 23 fixée sur un substrat 25 contenant une antenne 26, selon un mode de réalisation de l'invention.

Selon une étape 1, on applique de la résine 24 polymérisable au rayonnement UV et à la chaleur à l'emplacement de fixation de la puce électronique 23 sur le substrat 25.

Selon une étape 3, on met en place ladite puce électronique 23 sur son emplacement de fixation, la connectant ainsi à l'antenne 26.

Selon une étape 5, on effectue un traitement de polymérisation de la résine 24 par insolation UV. Du fait que la puce électronique 23 est imperméable aux rayons UV, cette insolation UV se fait au travers du substrat 25 afin que les rayons UV atteignent la plus grande surface possible de résine 24. Le substrat 25 est par conséquent réalisé en une matière perméable aux UV.

Selon une étape 7, un effectue un traitement thermique de polymérisation de la résine 24. La raison de ce traitement supplémentaire de polymérisation est que le traitement de polymérisation de l'étape 5 a laissé des zones « d'ombre » où la résine 24 ne c'est pas bien polymérisée. En effet, l'antenne 26 est, à l'instar de la puce électronique 23, imperméable aux rayons UV, ainsi la résine 24 située entre la puce électronique 23 et l'antenne 26 n'a pas reçue suffisamment de rayons UV pour se polymériser correctement. Cela peut générer à terme, des problèmes de durabilité lors du vieillissement du module électronique.

L'étape 7 de traitement thermique permet ainsi de polymériser la résine 24 dans ces zones « d'ombre ».

Ladite étape 7 peut être effectuée dans la foulée de l'étape 6 de polymérisation de la résine 24 par insolation UV. Elle est ensuite suivie d'une étape de découpe du substrat 25 au format désiré.

Une variante de l'étape 7 est de l'effectuer à postériori, par exemple en utilisant la chaleur émise lors de la lamination des couches lors de la fabrication d'une carte sans contacts et de l'encartage dudit module électronique. Dans ce cas, l'étape de découpe du substrat 25 au format désiré est effectuée avant l'étape 7 de traitement thermique de polymérisation de la résine 24, afin de pouvoir encarter le module électronique par exemple en l'encartant lors de la fabrication d'une carte sans contacts.

La figure 3 montre sous forme d'organigramme les différentes étapes de procédé de fabrication d'un module électronique comportant une puce électronique 23 fixée sur un substrat 25 contenant une antenne 26, selon un autre mode de réalisation de l'invention.

Les étapes identiques du procédé décrit par la figure 2 portent les mêmes numéros de référence. Le mode de réalisation se différencie de celui décrit par la figure 2 par une étape 2 intermédiaire où l'on superpose une couche compensatrice 21 sur le substrat 25. Il a été préalablement formé un trou de compensation 22 dans ladite couche compensatrice 21. Ledit trou de compensation 22 vient se placer au niveau de l'emplacement de fixation de la puce 23 sur le substrat 25_{.}

Cette superposition consiste à appliquer ladite couche compensatrice 21 sur le substrat 25 et de les solidariser, afin que durant la suite du procédé, lesdites couches soient immobiles l'une par rapport à l'autre. Cette solidarisation des couches est effectuée par exemple grâce à un pointage par ultrason, créant ainsi des points de soudures.

Cette couche compensatrice 21 a une double fonction, elle permet de compenser l'épaisseur de la puce électronique 23 et ainsi d'obtenir un module électronique plat, mais ladite couche 21 permet également, du fait qu'elle soit superposée avant l'application de la résine 24 de fixation, de contenir dans le trou de compensation 22 ladite résine 24 de fixation. Le trou de compensation 22 joue ainsi également un rôle de « réservoir » ou de « barrage ».

La figure 4 montre sous forme d'organigramme les différentes étapes de procédé de fabrication d'un module électronique comportant une puce électronique 23 fixée sur un substrat 25 contenant une antenne 26, selon un autre mode de réalisation de l'invention.

Les étapes identiques du procédé décrit par la figure 2 portent les mêmes numéros de référence. Le mode de réalisation se différencie de celui décrit par la figure 2 par une étape 4 où une pellicule de résine 24, polymérisable sous rayonnement UV et à la chaleur, est déposée sur la puce électronique 23. Cette étape 4 est effectuée après l'étape 3 de mise en place de ladite puce électronique 23 sur son emplacement de fixation. Ladite étape 4 est suivie d'une étape 6 correspondant à un traitement de polymérisation par insolation UV de la résine 24. A l'instar de l'étape 5, une insolation UV est effectuée au travers du substrat 25, mais une insolation UV est également effectuée au dessus de la puce électronique 23, cela afin de polymériser la pellicule de résine 24 qui la recouvre. On retrouve ensuite l'étape 7 de traitement thermique de polymérisation.

Cette pellicule de résine permet, après polymérisation, de former une couche protectrice ou « globe top » au dessus de ladite puce électronique.

Ces étapes 4 et 6 sont utiles si la puce électronique 23 et une puce nue, sans protections. Cependant, la puce électronique 23 peut déjà être déjà enrobée, par exemple par une couche plastique, ne laissant ressortir que les pattes de connexion. On trouve ce genre de puce électronique enrobé dans le commerce.

Le procédé de fabrication présenté par la figure 4 peut également comprendre l'étape 2 intermédiaire de superposition d'une couche compensatrice 21 décrit lors du procédé de fabrication présenté par la figure 3.

Le procédé de fabrication d'un module électronique comportant une puce électronique 23 fixée sur un substrat 25 contenant une antenne 26 selon l'invention, a également l'avantage d'être applicable dans une chaine de production où les différentes couches formant le module électronique, que ce soit le soit le substrat 25 et son antenne 26 ou la couche compensatrice 21, sont présentées sous forme de feuilles individuelles, mais également dans une chaine de production où ces mêmes couches sont présentées sous forme de rouleaux.

Les modules électroniques obtenus selon le procédé de fabrication de l'invention peuvent, par exemple, être utilisés lors de la fabrication de cartes à puces sans contacts. Ils peuvent également être utilisés lors de la fabrication de passeports numériques, dans le domaine des tickets de transport ou encore des étiquettes intelligentes ou « RFID » (Identification par Radio Fréquence).

Les couches formant le module électronique peuvent être en différentes matière suivant les produits finaux. Par exemple, on peut citer le Polychlorure de Vinyle (PVC), le Polyéthylène Téréphtalate (PET) ou encore le Polycarbonate (PC) pour une utilisation ultérieure dans des cartes à puces sans contacts. On peut également citer le papier synthétique pour les passeports numériques et le papier pour les tickets de transport.

Le procédé de fabrication d'un module électronique comportant une puce électronique 23 fixée sur un substrat 25 contenant une antenne 26 selon l'invention, permet une meilleure polymérisation de résine et donc une meilleure fixation de la puce électronique. De plus un tel procédé permet dans une chaine de production de garder une cadence élevée et donc de baisser les coûts de productions.

Il y a donc un effet synergique entre le traitement de polymérisation de la résine sous rayonnement UV et celui à la chaleur, permettant une polymérisation complète de la résine sans allongement de la durée du procédé de fabrication.

## Revendications

1. Procédé de fabrication d'un module électronique comportant une puce électronique (23) fixée sur un substrat (25) contenant une antenne (26), **caractérisé en ce que** ledit procédé comporte les étapes suivantes :
- on applique de la résine (24) polymérisable au rayonnement UV et à la chaleur à l'emplacement de fixation de la puce électronique (23) sur le substrat (25),
- on met en place la puce électronique (23) sur son emplacement de fixation, la connectant à l'antenne (26),
- on effectue un traitement de polymérisation de la résine (24) par insolation UV au travers du substrat (25),
- on effectue un traitement thermique de polymérisation de la résine (24).

2. Procédé de fabrication d'un module électronique selon la revendication 1, **caractérisé en ce que** ledit procédé de fabrication comprend une étape intermédiaire où l'on superpose sur le substrat (25) une couche compensatrice (21), munie d'un trou de compensation (22) au niveau de l'emplacement de fixation de la puce électronique (23), avant l'étape d'application de la résine (24) polymérisable aux rayons UV et à la chaleur sur ledit emplacement de fixation de la puce électronique (23) sur le substrat (25).

3. Procédé de fabrication d'un module électronique selon les revendications 1 et 2, **caractérisé en ce que** le traitement thermique de polymérisation de la résine (24) est effectué consécutivement au traitement de polymérisation de la résine (24) par insolation UV.

4. Procédé de fabrication d'un module électronique selon les revendications 1 à 3, **caractérisé en ce que** le traitement thermique de polymérisation de la résine (24) est suivi d'une étape de découpe du substrat (25) au format désiré.

5. Procédé de fabrication d'un module électronique selon les revendications 1 ou 2, **caractérisé en ce que** le traitement de polymérisation de la résine (24) par insolation UV au travers du substrat (25) est suivi d'une étape de découpe dudit substrat (25) au format désiré.

6. Procédé de fabrication d'un module électronique selon les revendications 1, 2 ou 5, **caractérisé en ce que** le traitement thermique de polymérisation de la résine (24) est effectué lors de la lamination des couches au moment de l'encartage dudit module électronique.

7. Procédé de fabrication d'un module électronique selon les revendications 1 à 6, **caractérisé en ce que** suite à l'étape de mise en place de la résine (24) sur l'emplacement de fixation de la puce électronique (23) sur le substrat (25), on effectue une étape supplémentaire de pré-polymérisation de la résine (24) par insolation UV par dessus l'emplacement de fixation de ladite puce électronique (23) sur ledit substrat (25).

8. Procédé de fabrication d'un module électronique selon les revendications 1 à 7, **caractérisé en ce que** suite à l'étape de mise en place de la puce électronique (23) sur son emplacement de fixation, on effectue une étape supplémentaire où une pellicule de résine (24), polymérisable sous rayonnement UV et à la chaleur, est déposée sur ladite puce électronique (23) et l'étape suivante de traitement de polymérisation de la résine (24) par d'insolation UV est effectuée aussi bien au travers du substrat (25) que pardessus l'emplacement de fixation de la puce électronique (23).

9. Procédé de fabrication d'un module électronique selon les revendications 1 à 8, **caractérisé en ce que** la puce électronique (23) est une puce nue.

10. Procédé de fabrication d'un module électronique selon les revendications 1 à 8, caractérisé en que la puce électronique (23) est une puce enrobée.

11. Procédé de fabrication d'un module électronique selon les revendications 1 à 10, **caractérisé en ce que** la ou les couches formants ledit module électronique se présentent sous forme de feuilles individuelles avant la mise en oeuvre du procédé.

12. Procédé de fabrication d'un module électronique selon les revendications 1 à 10, **caractérisé en ce que** la ou les couches formants ledit module électronique se présentent sous forme de rouleaux avant la mise en oeuvre du procédé.
